# EUROPEAN PATENT SPECIFICATION

(11) **EP 3 056 719 B1**
(45) Date of publication and mention of the grant of the patent: **12.05.2021**
(21) Application number: 14852466.3
(22) Date of filing: 06.10.2014
(51) Int. Cl.: F02D 41/28, F02P 17/12, G01L 23/22, F02D 35/02, F02D 41/22, F02P 5/152

(54) **CONTROL DEVICE OF AN INTERNAL COMBUSTION ENGINE**
STEUERUNGSVORRICHTUNG EINES VERBRENNUNGSMOTORS
DISPOSITIF DE COMMANDE DE MOTEUR À COMBUSTION INTERNE

(30) Priority: 08.10.2013 JP 2013211127
(43) Date of publication of application: 17.08.2016
(73) Proprietor: Hitachi Automotive Systems, Ltd., Hitachinaka-shi, Ibaraki 312-8503 (JP)
(72) Inventor: MATOHARA, Shinya, Hitachinaka-shi Ibaraki 312-8503 (JP); KUMANO, Kengo, Tokyo 100-8280 (JP); AKAGI, Yoshihiko, Hitachinaka-shi Ibaraki 312-8503 (JP)
(74) Representative: MERH-IP Matias Erny Reichl Hoffmann Patentanwälte PartG mbB
(86) International application number: PCT/JP2014/076648
(87) International publication number: WO 2015/053204

(56) References cited:
- EP-A1- 2 253 833
- JP-A- H1 172 075
- JP-A- H07 279 743
- JP-A- 2003 021 032
- JP-A- 2007 187 076
- JP-A- 2009 221 990
- US-A- 6 091 244
- US-A1- 2002 014 108
- US-A1- 2004 074 476
- US-A1- 2009 108 846

## Description

The present invention relates to a control device of an internal combustion engine that detects a combustion state thereof using an ionic current generated during combustion. Background Art

In recent years, controls on vehicles such as automobiles over fuel consumption and exhaust gases have been tightened and such controls are expected to be tightened still more in the future. Particularly, controls over fuel consumption are a matter of immensely high interest due to problems of strong appreciation in fuel prices in recent years, the effect on global warming, and depletion of energy resources.

Under such circumstances, in the automobile industry, for example, development of various technologies for the purpose of improving fuel consumption performance and exhaust performance of vehicles is promoted. As one of technologies developed for the purpose of improving fuel consumption performance, for example, a high compression ratio technology to increase the compression ratio of an internal combustion engine can be cited. Also, as one of technologies developed for the purpose of improving exhaust performance, for example, a multistage injection technology that injects fuel a plurality of times during an intake stroke to reduce PN (Particulate Number) by reducing the fuel injection quantity each time.

Incidentally, in the above high compression ratio technology, when the compression ratio of an internal combustion engine is increased, the fuel consumption is improved due to improved thermal efficiency, but it is known that knocking is more likely to occur due to a higher temperature inside the combustion chamber.

Therefore, in a conventional internal combustion engine, using the fact that the level of a specific frequency signal rises when knocking occurs, a vibration type knocking sensor is mounted on a cylinder block and FFT (fast Fourier transform) analysis of a signal output from the knocking sensor in a predetermined period (knocking window) is conducted to detect an occurrence of knocking.

However, the knocking sensor mounted on the conventional internal combustion engine is a type that transmits vibrations of the internal combustion engine and thus, if injector noise arises in the knocking window, the noise may erroneously be detected as knocking thus, a fuel injection period cannot be set during a knocking window and so, for example, a problem of being unable to make good use of potentials of the multistage injection technology that reduces PN may arise.

Confronted with such a problem, EP 0 828 076 A2 discloses a technology that detects an occurrence of knocking without being affected by injector noise by detecting ions (called an ionic current) generated during combustion.

The knocking detection device of an internal combustion engine disclosed in EP 0 828 076 A2 determines whether knocking occurs based on a signal of knocking frequency components extracted from an ionic current signal and prohibits a determination whether knocking occurs to prevent an erroneous determination that knocking occurs when a low-load noise frequency component having a frequency lower than a knocking frequency extracted from the ionic current signal is higher than a predetermined level.

US 2009/108846 A1 discloses A combustion state detection apparatus for an internal combustion engine, which includes convexity detection means for detecting that domain within the detection interval in which the change shape of the ionic current is upwardly convex, on the basis of the ionic current data extracted by data extraction means. Preignition decision means including comparison setting means are provided for setting a comparison value with which the upwardly convex domain is compared, and functioning to decide the occurrence of the preignition or the premonitory phenomenon thereof.

EP 2 253 833 A1 discloses a detection of a current generated on a secondary side of an ignition coil caused by an LC resonance between the secondary side of the ignition coil and a spark plug at an end of discharge of the spark plug. A combustion state is determined based on a shape of the waveform caused by the LC resonance of the detected current.

US 2004/074476 A1 discloses a knock control apparatus that normalizes a knock frequency magnitude and a background noise level to substantially the same levels in all the engine operating conditions.

US 6 091 244 A discloses a method of detecting combustion misfires of an internal combustion engine wherein an ion current is generated during the operation of the engine. The ion current signal is detected over a pregiven time interval starting with the discharge of a spark plug.

### Summary of Invention

### Technical Problem

However, an ionic current generated during combustion changes depending on the combustion state of an internal combustion engine and thus, the detected waveform of the ionic current is a waveform that is different from combustion cycle to combustion cycle. That is, even if operating conditions of the internal combustion engine are substantially the same, the detected waveform of an ionic current fluctuates significantly. Thus, the signal level of an extracted knocking frequency component rises with an increasing signal level of an ionic current and dips with a decreasing signal level of an ionic current and if a knocking vibration component contained in the ionic current when knocking occurs is feeble, it becomes difficult to finely extract the knocking vibration component from an ionic current signal and experiments of the present inventors and others confirm that it becomes difficult to detect an occurrence of knocking from the ionic current signal.

Therefore, the correlation between an ionic current signal and knocking may decrease in the knocking detection device disclosed in EP 0 828 076 A2 to extract a knocking frequency component by conducting the frequency analysis of the ionic current signal and a problem that it becomes difficult to determine whether knocking occurs from the ionic current signal containing the knocking frequency component may arise.

The present invention is made in view of the above problem and an object thereof is to provide a control device of an internal combustion engine in a simple configuration capable of finely detecting the combustion state of the internal combustion engine, for example, an occurrence of knocking from an ionic current signal.

### Solution to Problem

To solve the above problem, a control device of an internal combustion engine according to the present invention is proposed, as defined by appended claim 1. Accordingly, there is a control device of an internal combustion engine having an ionic current value detection unit that detects an ionic current value during combustion, the control device including an ionic current signal processing unit that performs signal processing of the ionic current value and a detection unit that detects a combustion state of the internal combustion engine based on a processing result by the ionic current signal processing unit, wherein the ionic current signal processing unit includes differentiating unit that calculates differential value of the ionic current value. The control device further comprising a drive circuit that controls ignition timing of an ignition system of the internal combustion engine based on a vibration strength of the internal combustion engine detected by the detection unit depending on the signal processing of the ionic current value, wherein the ionic current signal processing unit further includes a frequency analyzer that conducts frequency analysis of the differential value, and an operation unit that calculates a vibration strength by integrating, among analysis results sent from the frequency analyzer, the signal level of a knocking frequency band.

### Advantageous Effects of Invention

According to the present Invention, as is understood from the above description, by detecting the combustion state of an internal combustion engine using a differential value as the amount of change of an ionic current value, even if, for example, a knocking vibration component contained in the ionic current when knocking occurs is feeble, the knocking vibration component can reliably be extracted from the ionic current regardless of the absolute value of the ionic current value and therefore, the combustion state of the internal combustion engine, for example, an occurrence of knocking can finely be detected.

Other problems, configurations, and effects than those described above will be apparent from the description of embodiments described below.

### Brief Description of Drawings

[FIG. 1] FIG. 1 is an overall configuration diagram showing an overall configuration of an internal combustion engine to which a first embodiment of a control device of the internal combustion engine according to the present invention is applied.
[FIG. 2] FIG. 2 is an internal configuration diagram showing an internal configuration of an ignition system shown in FIG. 1.
[FIG. 3] FIG. 3 is a block diagram showing the internal configuration of the control device shown in FIG. 1.
[FIG. 4] FIG. 4 is a diagram showing examples of an ignition signal input into the ignition system shown in FIG. 1 and an ionic current signal output from the ignition system.
[FIG. 5] FIG. 5 is a diagram showing an example of the relationship between knocking strength and ionic current value vibration strength.
[FIG. 6] FIG. 6 is a diagram showing an example of the relationship between knocking strength and ionic differential value vibration strength.
[FIG. 7] FIG. 7 is a diagram showing examples of an ignition signal input into the ignition system shown in FIG. 1 and an ionic differential value of the ionic current signal output from the ignition system.
[FIG. 8] FIG. 8 is a block diagram showing the internal configuration of CPU of the control device shown in FIG. 3.
[FIG. 9] FIG. 9 is a flowchart showing a knocking detection flow and a knocking avoidance control flow by the control device shown in FIG. 1.
[FIG. 10] FIG. 10 is a diagram showing an example of the ionic current signal when the absolute value of the ionic current value is large.
[FIG. 11] FIG. 11 is a diagram showing an example of an ionic current waveform when the absolute value of the ionic current value is small.
[FIG. 12] FIG. 12 is a diagram showing an example of the relationship between the knocking strength and a normalized value obtained by dividing the ionic differential value vibration strength by an ionic integral value.
[FIG. 13] FIG. 13 is a diagram schematically illustrating an example of an integration range of the ionic integral value.
[FIG. 14] FIG. 14 is a block diagram showing the internal configuration of a second embodiment of a control device of the internal combustion engine according to the present invention.
[FIG. 15] FIG. 15 is a flowchart showing the knocking detection flow and the knocking avoidance control flow by the control device shown in FIG. 14.
[FIG. 16] FIG. 16 is a diagram showing an example of the relationship between the knocking strength and ionic rate-of-change vibration strength.
[FIG. 17] FIG. 17 is a diagram schematically illustrating a method of calculating the ionic rate-of-change vibration strength.
[FIG. 18] FIG. 18 is a block diagram showing the internal configuration of a third embodiment of a control device of the internal combustion engine according to the present invention.
[FIG. 19] FIG. 19 is a flowchart showing the knocking detection flow and the knocking avoidance control flow by the control device shown in FIG. 18.

### Description of Embodiments

Hereinafter, the embodiments of the control device of an internal combustion engine according to the present invention will be described with reference to the drawings. In the present embodiment, a form of detecting, among combustion states of an internal combustion engine, an occurrence of knocking is described.

### [First embodiment]

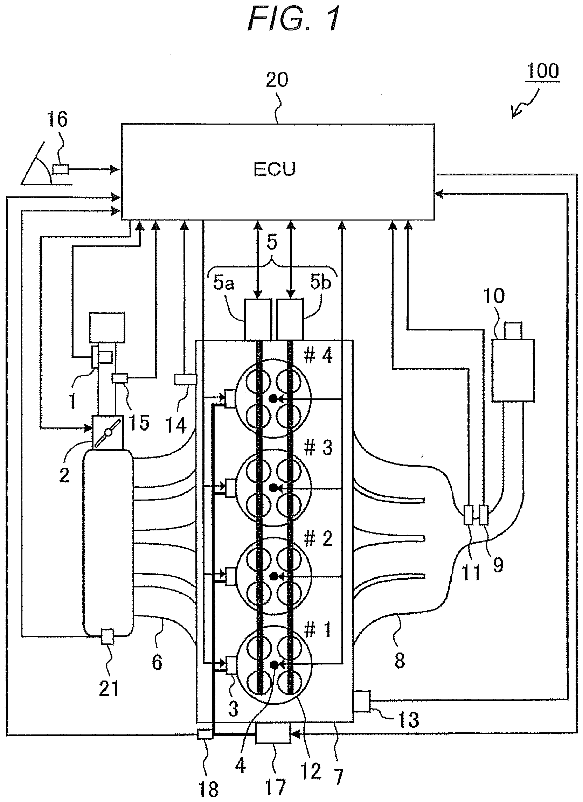

FIG. 1 shows an overall configuration of an internal combustion engine to which the first embodiment of a control device of the internal combustion engine according to the present invention is applied and shows, for example, a 4-cylinder gasoline engine for automobiles implementing spark ignition combustion.

An engine (internal combustion engine) 100 illustrated in FIG. 1 includes an air flow sensor 1 that measures the amount of intake air, an electronic control throttle 2 that regulates the pressure of an intake pipe 6, an intake temperature sensor 15 that, as a form of an intake air temperature detector, measures the intake air temperature, and an intake pressure sensor 21 that measures the pressure inside the intake pipe 6 in an appropriate position of the intake pipe 6.

The engine 100 also includes a fuel injector (also called an injector for cylinder direct injection or simply an injector) 3 that injects fuel into a combustion chamber 12 of each cylinder and an ignition system 4 that supplies ignition energy for each cylinder (#1 to #4) communicatively connected to each of the intake pipes 6. In addition, the engine 100 includes a cooling water temperature sensor 14 that measures the cooling water temperature of the engine 100 and also a variable valve 5 including an intake valve variable device 5a that regulates an intake gas flowing into the cylinder and an exhaust valve variable device 5b that regulates an exhaust gas discharged from inside the cylinder in an appropriate position of a cylinder head 7. The variable valve 5 includes a phase angle sensor (not shown) that detects a phase angle of the intake valve variable device 5a or the exhaust valve variable device 5b and can regulate the intake amount and the EGR amount of all cylinders from #1 to #4 by regulating the variable valve 5 (particularly the phase angle of the intake valve variable device 5a or the exhaust valve variable device 5b) by ECU 20 described below. A high-pressure fuel pump 17 to supply high-pressure fuel to the fuel injector 3 is connected to the fuel injector 3 of the engine 100 via a fuel pipe, the fuel pipe is provided with a fuel pressure sensor 18 to measure the fuel pressure, and a crank angle sensor 13 to calculate the rotation angle of the engine 100 is provided on the crankshaft (not shown) thereof.

Further, the engine 100 includes a three-way catalyst 10 that cleans up an exhaust gas, an air-fuel ratio sensor 9 that detects, as a form of an air-fuel detector, an air-fuel ratio of an exhaust gas upstream of the three-way catalyst 10, and an exhaust temperature sensor 11 that, as a form of an exhaust temperature detector, measures the exhaust temperature upstream of the three-way catalyst 10 in an appropriate position of an exhaust pipe 8.

The engine 100 includes the engine control unit (ECU) (control device) 20 that controls the combustion state of the engine 100 and signals obtained from the air flow sensor 1, the air-fuel ratio sensor 9, the cooling water temperature sensor 14, the intake temperature sensor 15, the exhaust temperature sensor 11, the crank angle sensor 13, the fuel pressure sensor 18, the intake pressure sensor 21, the ignition system 4, and the variable valve 5 are sent to the ECU 20. Also, a stamping amount of an accelerator pedal, that is, a signal obtained from an accelerator opening sensor 16 that detects an accelerator opening is sent to the ECU 20.

The ECU 20 calculates required torque to the engine 100 based on a signal obtained from the accelerator opening sensor 16. The ECU 20 also calculates the rotational speed of the engine 100 based on a signal obtained from the crank angle sensor 13. In addition, the ECU 20 calculates an operational state of the engine 100 based on a signal obtained from outputs of the various sensors described above and also calculates main strokes related to the engine 100 such as the air flow rate, fuel injection quantity, ignition timing, throttle opening, stroke of a variable valve, and fuel pressure.

The fuel injection quantity calculated by the ECU 20 is converted into an opening valve pulse signal and sent to the fuel injector 3. Also, an ignition signal generated so as to be ignited in the ignition timing calculated by the ECU 20 is sent from the ECU 20 to the ignition system 4. In addition, the throttle opening calculated by the ECU 20 is sent to the electronic control throttle 2 as a throttle drive signal, the stroke of the variable valve is sent to the variable valve 5 as a variable valve drive signal, the fuel pressure is sent to the high-pressure fuel pump 17 as a high-pressure fuel pump drive signal.

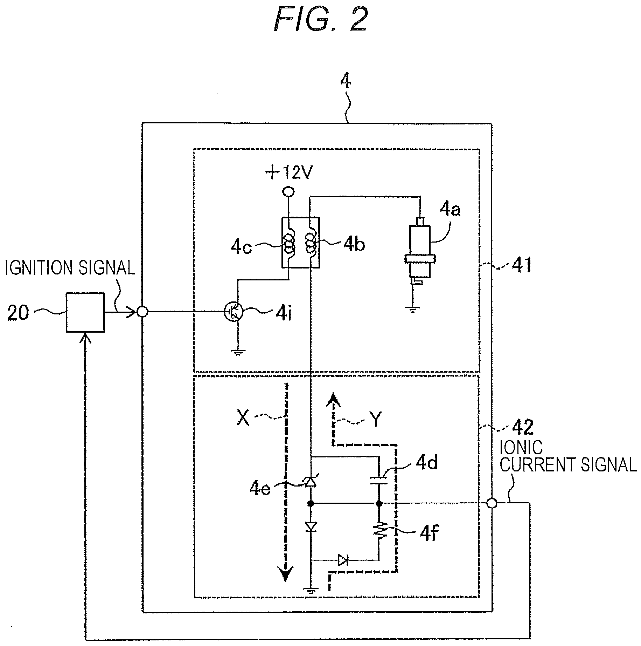

An air-fuel mixture is formed by a predetermined amount of fuel being injected from the fuel injector 3 into the air flowing into the combustion chamber 12 from the intake pipe 6 via an intake valve (not shown) based on an opening valve pulse signal sent from the ECU 20 to the fuel injector 3. The air-fuel mixture formed in the combustion chamber 12 is exploded by a spark generated by an ignition plug 4a (see FIG. 2) of the ignition system 4 in predetermined ignition timing based on an ignition signal and a piston (not shown) is pushed down by the combustion pressure thereof to generate a driving force of the engine 100. The exhaust gas after the explosion is sent out to the three-way catalyst 10 via the exhaust pipe 8 and exhaust components of the exhaust gas are cleaned up in the three-way catalyst 10 and discharged to the outside.

FIG. 2 shows an internal configuration of the ignition system shown in FIG. 1. The ignition system 4 illustrated in FIG. 2 mainly includes a spark ignition unit 41 that ignites an air-fuel mixture formed inside the combustion chamber 12 and an ionic current value detection unit 42 that detects the current value of an ionic current (ionic current value) generated during combustion.

To provide an overview of the ignition of an air-fuel mixture by the ignition system 4 and the generation of an ionic current, when an ignition signal is input from the ECU 20 into the ignition system 4, a current flows to a primary ignition coil 4c via an igniter 4i of the spark ignition unit 41. When the current on the primary side stops by the ignition signal being cut off, an electromotive force is generated in a secondary ignition coil 4b and a spark discharge occurs after a high voltage is applied to the tip of the ignition plug 4a. A current flows in an arrow X direction in the ionic current value detection unit 42 and the voltage of the secondary ignition coil 4b falls during spark ignition and if the voltage falls below the breakdown voltage (for example, 100 V) of a Zener diode 4e, the current flows into a capacitor 4d to be charged.

If a flame kernel is generated in a gap of the ignition plug 4a by a spark discharge, a flame propagates inside the combustion chamber 12. In this flame band, ions such as chemical ions and thermal ions are present as intermediate products of the combustion process. At this point, a voltage (100 V in this case) is applied to the ignition plug 4a by the capacitor 4d charged during spark discharge and an ionic current flows in an arrow Y direction inside the ionic current value detection unit 42 by cations (and electrons) in the combustion chamber 12 being trapped by the voltage. The ionic current is converted into a voltage by a voltage conversion resistor 4f and sent to the ECU 20 as an ionic current signal.

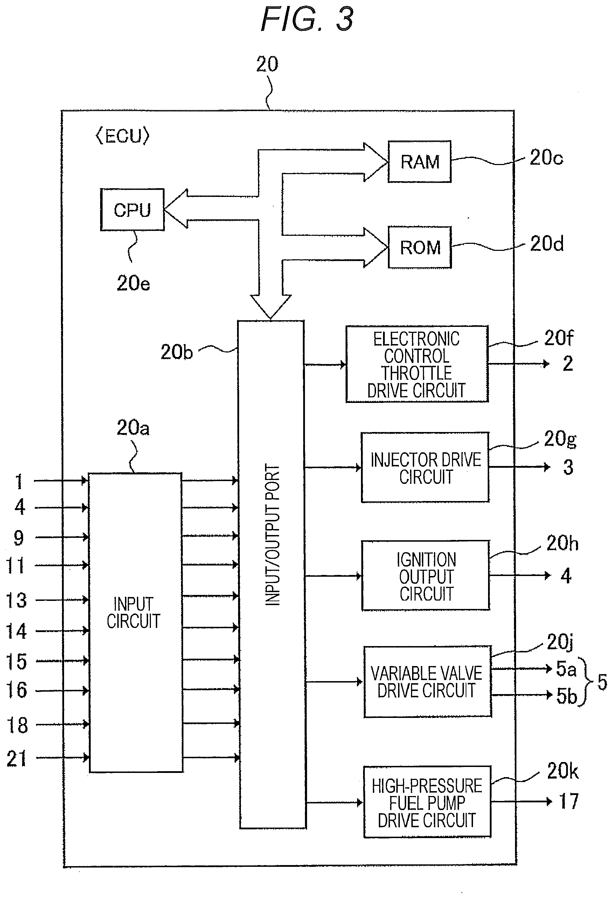

FIG. 3 shows the internal configuration of the ECU (control device) shown in FIG. 1. The ECU 20 illustrated in FIG. 3 mainly includes an input circuit 20a, an input/output port 20b including an input port and an output port, a ROM 20d in which a control program describing arithmetic processing content is stored, a CPU 20e to perform arithmetic processing according to the control program, a RAM 20c that stores values showing strokes of each actuator calculated according to the control program, and drive circuits 20f to 20k that control each actuator based on values showing strokes of each actuator

As illustrated in FIG. 3, output signals of the air flow sensor 1, the ignition system 4, the air-fuel ratio sensor 9, the exhaust temperature sensor 11, the crank angle sensor 13, the cooling water temperature sensor 14, the intake temperature sensor 15, the accelerator opening sensor 16, the fuel pressure sensor 18, the intake pressure sensor 21 and the like are input into the input circuit 20a of the ECU 20. However, input signals input into the input circuit 20a are not limited to the above signals. An input signal of each sensor input into the input circuit 20a is sent to the input port inside the input/output port 20b and stored in the RAM 20c and then processed by the CPU 20e according to the control program stored in the ROM 20d in advance.

The value showing a stroke of each actuator calculated by the CPU 20e according to the control program is stored in the RAM 20c and then sent to the output port inside the input/output port 20b and sent to each actuator (the electronic control throttle 2, the injector 3, the ignition system 4, the variable valve 5, the high-pressure fuel pump 17 and the like) via each drive circuit (an electronic throttle drive circuit 20f, an injector drive circuit 20g, an ignition output circuit 20h, a variable valve drive circuit 20j, a high-pressure fuel pump drive circuit 20k and the like). However, drive circuits in the ECU 20 are not limited to the above drive circuits.

As described above, an ionic current signal as an output signal of the ignition system 4 is input into the input circuit 20a of the ECU 20 and ECU 20 detects knocking of the engine 100 according to the control program stored in the ROM 20d in advance through the CPU 20e based on the input signal (ionic current signal). When an occurrence of knocking of the engine 100 is detected, the ECU 20 sends a control signal to the ignition system 4 via the ignition output circuit 20h to control the ignition timing thereof.

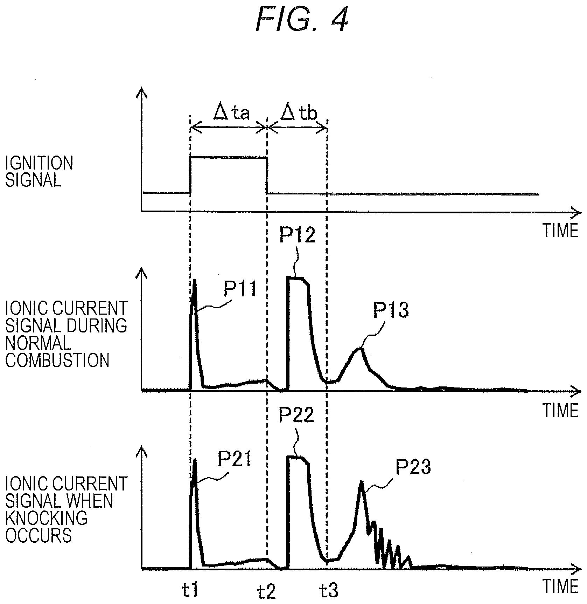

Next, the method of detecting knocking of the engine 100 by the ECU 20 will be described with reference to Figs 4 to 7.

FIG. 4 shows examples of the ignition signal input from ECU into the ignition system shown in FIG. 1 and an ionic current signal output from the ignition system into ECU and shows the ignition signal, the ionic current signal during normal combustion, and the ionic current signal when knocking occurs from above.

As illustrated in FIG. 4, the ionic current signal output from the ignition system 4 generally has, when the combustion is normal or knocking occurs, three mountains p11 to p13, p21 to p23. The first mountain p11, p21 is a waveform detected when the ionic current value detection unit 42 is contained in the ignition system 4 and is a waveform of the current flowing into the ionic current value detection unit 42 when an ignition signal is input at time t1 output and detected as an ionic current signal. The timing when the first mountain p11, p21 is detected is timing when no combustion flame is actually present in the combustion chamber 12 and thus, the mountain p11, p21 is handled as noise. The next mountain p12, p22 is a waveform detected after the ignition signal is cut off at time t2 after an energization time Δta and a spark kernel is generated in a gap of the ignition plug 4a and is a waveform formed, though no ionic current signal is detected while the spark kernel is generated in the gap thereof, by an ionic component in the flame in the initial stage of combustion thereafter being detected. The last mountain p13, p23 is a waveform detected in a process in which the combustion flame spreads to the combustion chamber 12 as a whole from time t3 after a discharge period Δtb, substantially matches a waveform of pressure inside the combustion chamber 12, and is a waveform formed by ion components in flames of main combustion portions being detected.

When knocking of the engine 100 occurs, changes appear mainly in the last mountain p23. More specifically, when knocking occurs, the pressure and the temperature in the combustion chamber 12 rises, the last mountain p23 becomes larger than the last mountain p13 for normal combustion, and a knocking vibration component (vibration component derived from an occurrence of knocking) having a knocking frequency (frequency specific to knocking) is contained in the last mountain p23.

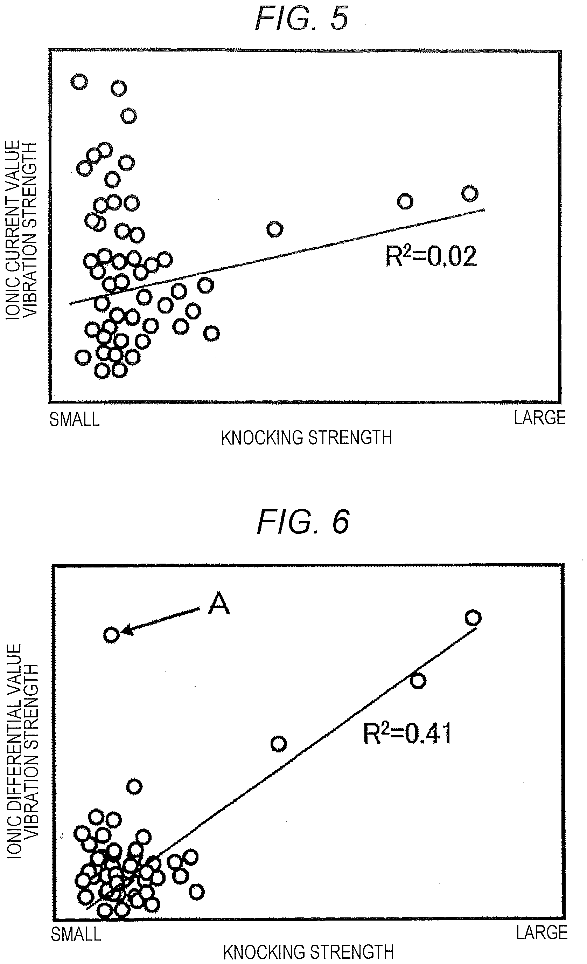

FIG. 5 is a diagram showing the relationship between the knocking strength and the ionic current value vibration strength. The knocking strength is a value related to an occurrence of knocking and is a value obtained by integrating, among results obtained by conducting frequency analysis, particularly FFT analysis of the rate of heat release in a knocking window, the signal level of a knocking frequency band. The rate of heat release is determined from the cylinder pressure and is highly relevant to the occurrence of knocking. When knocking occurs, a pressure vibration arises inside the cylinder and a vibration similarly appears due to the rate of heat release, leading to a higher knocking strength. On the other hand, no pressure vibration arises inside the cylinder when knocking does not occur and no vibration appears due to the rate of heat release, leading to a lower knocking strength. The ionic current value vibration strength is a value obtained by integrating, among results obtained by conducting FFT analysis of the ionic current signal in the knocking window, the signal level of a knocking frequency band.

It is verified that, as shown in FIG. 5, the correlation between the ionic current value vibration strength calculated by using results obtained by conducting FFT analysis of the ionic current signal in the knocking window and the knocking strength is generally low (the correlation coefficient R² is substantially 0.02) and the correlation between the ionic current value vibration strength and the occurrence of knocking is low. This is because the knocking vibration component contained in the ionic current when knocking occurs is feeble and the knocking vibration component is small compared with the ionic current signal to be based on and thus, the knocking vibration component is considered to be not correctly extractable from the ionic current signal.

In contrast, FIG. 6 shows the relationship between the knocking strength and the ionic differential value vibration strength. The ionic differential value vibration strength is a value obtained by integrating, among results obtained by conducting FFT analysis of an ionic differential value obtained by differentiating the ionic current signal in the knocking window, the signal level of a knocking frequency band. Incidentally, the ionic differential value means a difference of the ionic current value in a certain time width.

Though, as described above, the correlation between the ionic current value vibration strength calculated by using results obtained by conducting FFT analysis of the ionic current signal in the knocking window and the knocking strength is low, it is verified that, as shown in FIG. 6, the correlation between the ionic differential value vibration strength calculated by using results obtained by conducting FFT analysis of the ionic differential value in the knocking window and the knocking strength is high (the correlation coefficient R² is substantially 0.41) and the correlation between the ionic differential value vibration strength and the occurrence of knocking is relatively high. This is because the knocking vibration component is considered to be reliably extractable from the ionic current signal by calculating the ionic differential value by differentiating the ionic current signal as an amount of change of the ionic current signal even if the knocking vibration component contained in the ionic current is feeble. Thus, in the first embodiment, an occurrence of knocking of the engine 100 is detected based on the ionic differential value obtained by differentiating a chronological signal (ionic current signal) of the ionic current value in the knocking window.

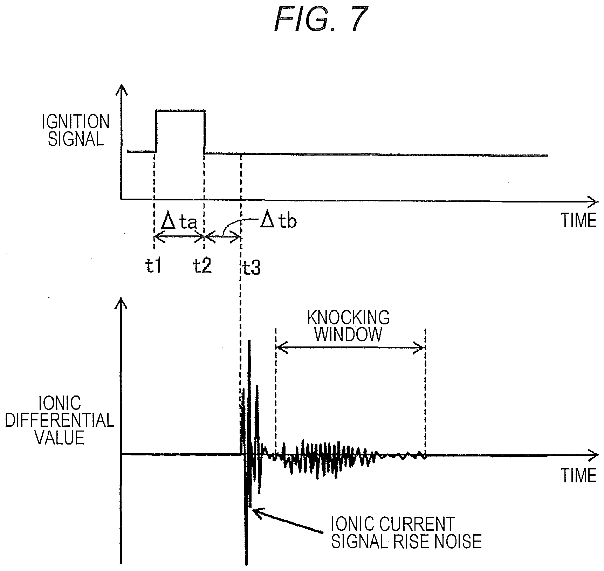

As described based on FIG. 4, after time t3 when the spark discharge ends and the combustion flame spreads to the combustion chamber 12 as a whole, a relatively large ionic current signal is detected and at the instant when the ionic current signal rises after time t3, as shown in FIG. 7, large noise may arise in the ionic current signal. Thus, to prevent the noise from being contained in the calculation of the ionic differential value vibration strength, the knocking window to calculate the ionic differential value vibration strength is set after the rise of the ionic current signal.

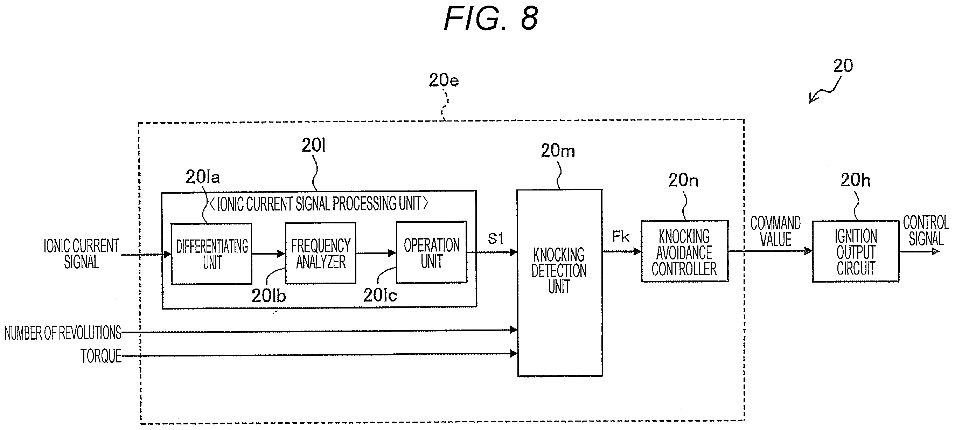

FIG. 8 shows the internal configuration of CPU of the ECU (control device) shown in FIG. 3 and particularly shows the configuration to detect knocking of the engine 100 based on an ionic current signal input from the ignition system 4 and to control the ignition timing of the ignition system 4 when an occurrence of knocking is detected.

As illustrated in FIG. 8, the CPU 20e of the ECU 20 mainly includes an ionic current signal processing unit 201 having a differentiating unit 201a that calculates a differential value of an ionic current value (ionic differential value), a frequency analyzer 201b that conducts frequency analysis of a differential value thereof, and an operation unit 201c that calculates ionic differential value vibration strength from analysis results thereof, a knocking detection unit (detection unit) 20m that detects an occurrence of knocking of the engine 100, and a knocking avoidance controller 20n that avoids further knocking by controlling the ignition timing of the ignition system 4.

An ionic current signal output from the ignition system 4 is input into the differentiating unit 201a of the ionic current signal processing unit 201 that processes the ionic current value as a signal. The differentiating unit 201a calculates an ionic differential value by differentiating the ionic current signal in a preset period (knocking window) and sends the calculation result to the frequency analyzer 201b. The frequency analyzer 201b conducts FFT analysis of the ionic differential value sent from the differentiating unit 201a and sends the analysis result to the operation unit 201c. The operation unit 201c calculates an ionic differential value vibration strength s1 by integrating, among analysis results sent from the frequency analyzer 201b, the signal level of the knocking frequency band and sends the calculation result to the knocking detection unit 20m.

In addition to the signal (ionic differential value vibration strength S1) processed by the ionic current signal processing unit 201, the number of revolutions and torque of the engine 100 are input into the knocking detection unit 20m. The knocking detection unit 20m calculates a knocking determination threshold (determination threshold) from the number of revolutions and torque input above and determines whether knocking has occurred by comparing the knocking determination threshold and the signal (ionic differential value vibration strength S1) input from the ionic current signal processing unit 201. When an occurrence of knocking of the engine 100 is detected, the knocking detection unit 20m sets a knocking determination flag Fk to 1 and outputs the flag to the knocking avoidance controller 20n.

If the knocking determination flag Fk from the knocking detection unit 20m is 1, the knocking avoidance controller 20n sends a command value to the ignition output circuit 20h such that the ignition timing of the ignition system 4 lags to avoid further knocking. Based on the command value, the ignition output circuit 20h creates a control signal and sends the created control signal to the ignition system 4 to control the ignition timing thereof.

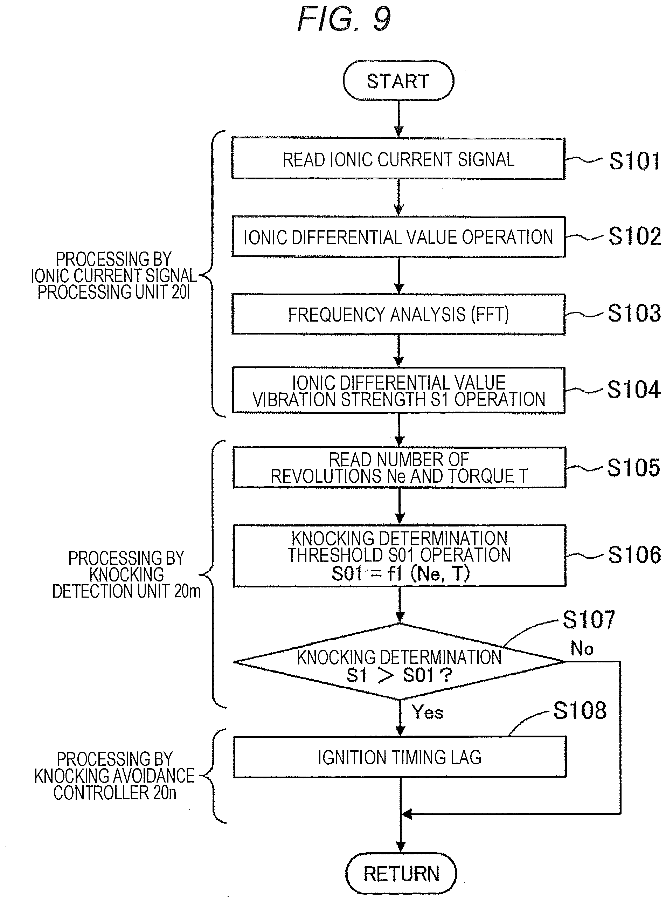

FIG. 9 concretely shows a knocking detection flow and a knocking avoidance control flow by the ECU (control device) shown in FIG. 1. The control flow shown in FIG. 9 is repeatedly performed by the ECU 20 in a predetermined period.

First, in S101, the ECU 20 reads an ionic current signal output from the ignition system 4. Next, in S102, the ECU 20 calculates an ionic differential value by differentiating an ionic current signal in the preset period (knocking window) through the differentiating unit 201a of the ionic current signal processing unit 201. Next, in S103, the ECU 20 conducts frequency (FFT) analysis of the ionic differential value sent from the differentiating unit 201a through the frequency analyzer 201b. Here, in S103, it is necessary to determine frequency components of a few kHz to a few tens of kHz and thus, the arithmetic processing from S101 to S103 needs to be performed far faster (for example, a few tens of µs or so) than the period of control (for example, 2 ms) performed by the ECU 20. On the other hand, arithmetic processing from S104 to S108 below is performed in the period of control (for example, 2 ms) performed by the ECU 20.

In S104, the ECU 20 calculates the ionic differential value vibration strength S1 by integrating, among analysis results sent from the frequency analyzer 201b, the signal level of the knocking frequency band through the operation unit 201c and sends the operation result to the knocking detection unit 20m. Next, in S105, the ECU 20 reads a number of revolutions Ne and torque T of the engine 100 and in S106, calculates a knocking determination threshold S01 set for each operating condition through the knocking detection unit 20m. Next, in S107, the ECU 20 compares to determine whether the ionic differential value vibration strength S1 sent from the operation unit 201c is larger than the knocking determination threshold S01 and if S1 ≤ S01, terminates a set of control by determining that no knocking has occurred. On the other hand, if S1 > S01, the ECU 20 determines that knocking has occurred and in S108, controls the ignition timing of the ignition system 4 through the knocking avoidance controller 20n such that the ignition timing of the ignition system 4 is on the lagging side of the current value.

According to the first embodiment, as described above, the knocking vibration component can reliably be extracted from an ionic current signal and the occurrence of knocking of the engine 100 can finely be detected by detecting an occurrence of knocking of the engine 100 using the differential value as an amount of change of the ionic current signal even if the knocking vibration component contained in the ionic current when knocking occurs is feeble. In addition, the combustion state of the engine 100 can finely be controlled by exercising knocking avoidance control by controlling the ignition timing based on the detection result.

### [Second embodiment]

Incidentally, in the relationship between the knocking strength and the ionic differential value vibration strength shown in FIG. 6, the ionic differential value vibration strength may deviate from the overall correlation even if the knocking strength is equal (A point, for example).

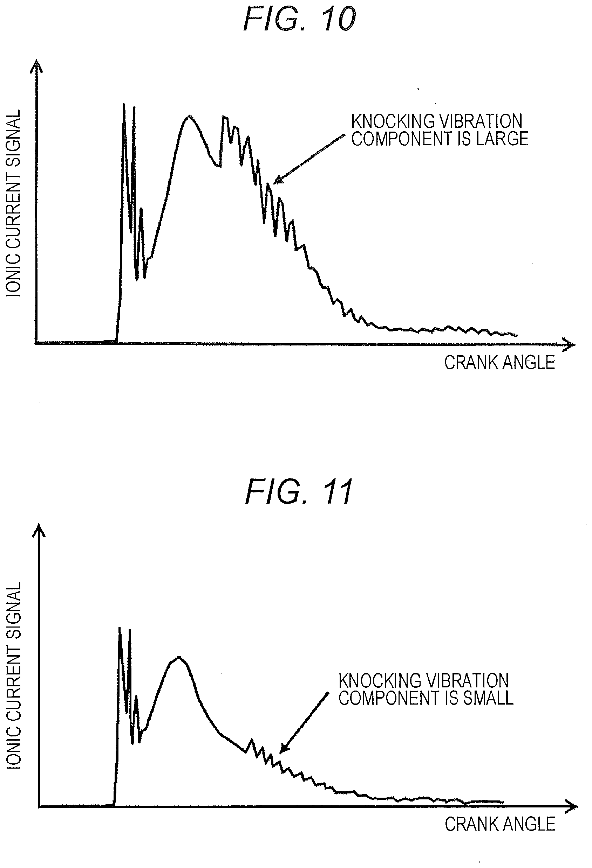

To give an outline of the reason therefor with reference to FIGS. 10 and 11, when the absolute value of an ionic current signal is large, as shown in FIG. 10, the knocking vibration component contained in the ionic current also becomes large and when the absolute value of an ionic current signal is small, as shown in FIG. 11, the knocking vibration component contained in the ionic current also becomes small. Like the combustion pressure, the ionic current also changes in waveform from combustion cycle to combustion cycle and depending on the absolute value of an ionic current signal when knocking occurs to be based on, a significant difference of the ionic differential value vibration strength arises even if the knocking strength is equal.

Thus, to further improve detection precision of an occurrence of knocking of the engine 100 by removing the influence of the absolute value of an ionic current signal to be based on to further increase the correlation between the knocking strength and the ionic differential value vibration strength, detecting an occurrence of knocking of the engine 100 based on a normalized value of the ionic differential value vibration strength normalized based on an ionic integral value obtained by integrating a chronological signal (ionic current signal) of the ionic current value in the cycle (in the knocking window or one cycle as a whole) can be considered.

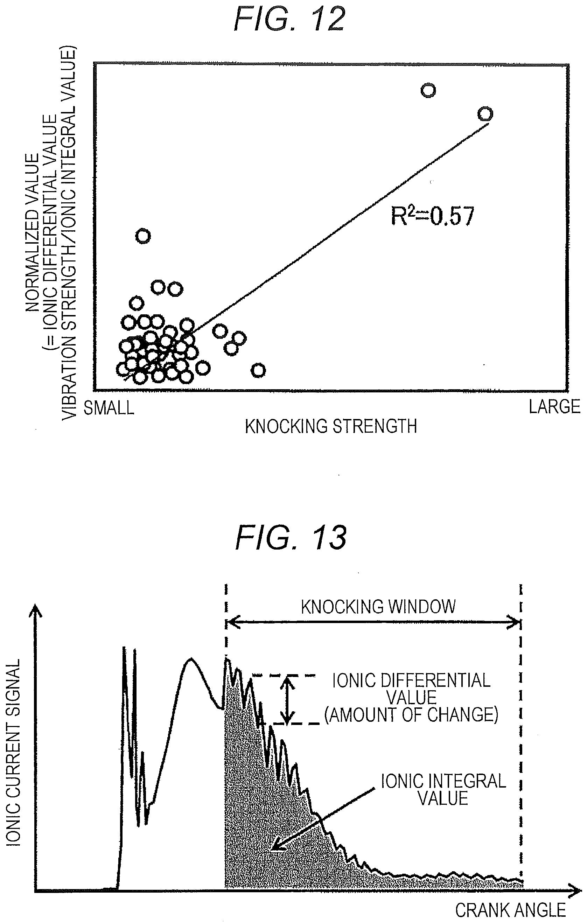

FIG. 12 shows the relationship between the knocking strength and a normalized value obtained by dividing the ionic differential value vibration strength by an ionic integral value. As illustrated in FIG. 12, it is verified that the correlation between the normalized value obtained by dividing the ionic differential value vibration strength calculated by using results obtained by conducting the FFT analysis of an ionic differential value in the knocking window by the ionic integral value and the knocking strength is higher (the correlation coefficient R² is substantially 0.57). This is because the influence of the absolute value of an ionic current signal for each combustion cycle is considered to be removable by dividing the ionic differential value by the ionic integral value in the cycle. Thus, in the second embodiment, an occurrence of knocking of the engine is detected based on the normalized value obtained by normalizing the ionic differential value vibration strength based on the ionic integral value.

The integration range when an ionic integral value is calculated may be set, as shown in FIG. 13, so as to include an ionic current signal during combustion and may be limited to, for example, the knocking window or the whole one cycle may be set.

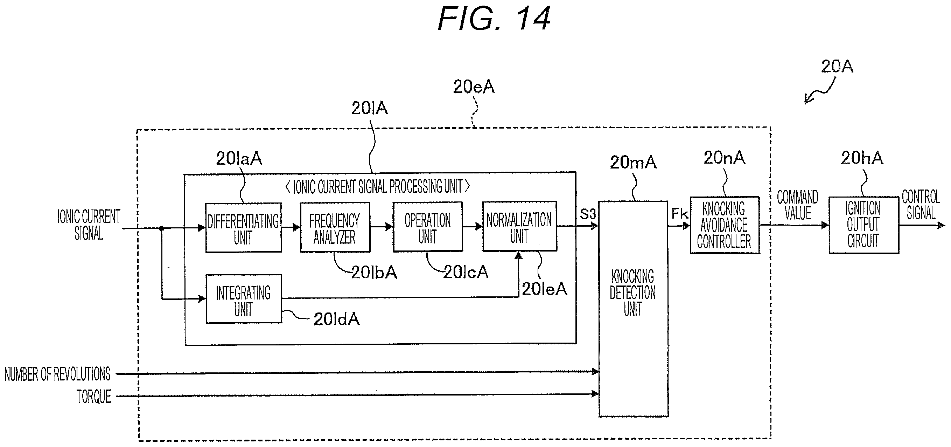

FIG. 14 shows the internal configuration of the second embodiment of ECU (control device) of the internal combustion engine according to the present invention and particularly shows the configuration in which knocking of an engine is detected based on an ionic current signal input from the ignition system and when an occurrence of knocking is detected, the ignition timing of the ignition system is controlled.

The control device in the second embodiment shown in FIG. 14 is different from the control device in the first embodiment described above in the method of detecting knocking of an engine and the other configuration is the same as that of the control device in the first embodiment. Thus, a detailed description of the configuration that is the same as that of the control device in the first embodiment is omitted.

As illustrated in FIG. 14, CPU 20eA of ECU 20A mainly includes an ionic current signal processing unit 20lA that processes the ionic current value as a signal, a knocking detection unit (detection unit) 20mA that detects an occurrence of knocking of an engine, and a knocking avoidance controller 20nA that avoids further knocking by controlling the ignition timing of the ignition system.

The ionic current signal processing unit 20lA mainly includes a differentiating unit 20laA that calculates a differential value of an ionic current value (ionic differential value), a frequency analyzer 20lbA that conducts frequency analysis of a differential value thereof, an operation unit 20lcA that calculates ionic differential value vibration strength from analysis results thereof, an integrating unit 20ldA that calculates an integral value of an ionic current value (ionic integral value), and a normalization unit 20leA that calculates a normalized value from the ionic differential value vibration strength of the operation unit 20lcA and the integral value of the integrating unit 20ldA.

An ionic current signal output from the ignition system is input into the differentiating unit 20laA and the integrating unit 20ldA of the ionic current signal processing unit 20lA. The differentiating unit 20laA calculates an ionic differential value by differentiating the ionic current signal in a preset period (knocking window) and sends the calculation result to the frequency analyzer 20lbA. The frequency analyzer 20lbA conducts FFT analysis of the ionic differential value sent from the differentiating unit 20laA and sends the analysis result to the operation unit 20lcA. The operation unit 20lcA calculates the ionic differential value vibration strength S1 by integrating, among analysis results sent from the frequency analyzer 20lbA, the signal level of the knocking frequency band and sends the calculation result to the normalization unit 20leA. The integrating unit 20ldA calculates an ionic integral value S2 by integrating an ionic current signal in the cycle (in the knocking window or one cycle as a whole) and sends the calculation result to the normalization unit 20leA. The normalization unit 20leA calculates a normalized value S3 by dividing the ionic differential value vibration strength S1 sent from the operation unit 20lcA by the ionic integral value S2 sent from the integrating unit 20ldA and sends the calculation result to the knocking detection unit 20mA.

In addition to the signal (normalized value S3) processed by the ionic current signal processing unit 20lA, the number of revolutions and torque of the engine are input into the knocking detection unit 20mA. The knocking detection unit 20mA calculates a knocking determination threshold (determination threshold) from the number of revolutions and torque input above and determines whether knocking has occurred by comparing the knocking determination threshold and the signal (normalized value S3) input from the ionic current signal processing unit 20lA. When an occurrence of knocking of the engine is detected, the knocking detection unit 20mA sets a knocking determination flag Fk to 1 and outputs the flag to the knocking avoidance controller 20nA.

If the knocking determination flag Fk from the knocking detection unit 20mA is 1, the knocking avoidance controller 20nA sends a command value to the ignition output circuit 20hA such that the ignition timing of the ignition system lags to avoid further knocking. Based on the command value, the ignition output circuit 20hA creates a control signal and sends the created control signal to the ignition system to control the ignition timing thereof.

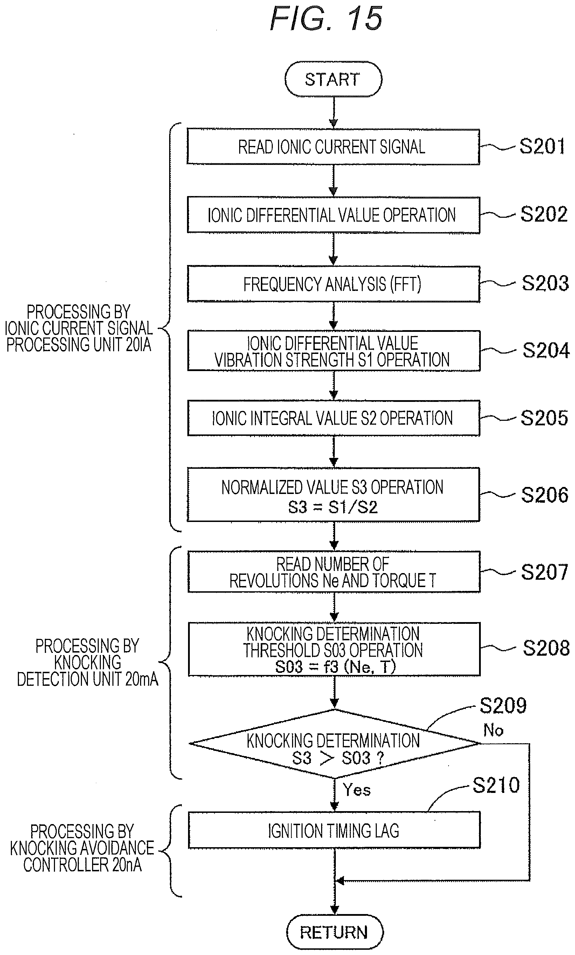

FIG. 15 concretely shows the knocking detection flow and the knocking avoidance control flow by the ECU (control device) shown in FIG. 14. The control flow shown in FIG. 15 is repeatedly performed by the ECU 20A in a predetermined period.

First, in S201, the ECU 20A reads an ionic current signal output from the ignition system. Next, in S202, the ECU 20A calculates an ionic differential value by differentiating the ionic current signal in the preset period (knocking window) through the differentiating unit 201aA of the ionic current signal processing unit 201A. Next, in S203, the ECU 20A conducts the frequency (FFT) analysis of the ionic differential value sent from the differentiating unit 201aA through the frequency analyzer 20lbA. Here, in S203, it is necessary to determine frequency components of a few kHz to a few tens of kHz and thus, the arithmetic processing from S201 to S203 needs to be performed far faster (for example, a few tens of µs or so) than the period of control (for example, 2 ms) performed by the ECU 20A. On the other hand, arithmetic processing from S204 to S210 below is performed in the period of control (for example, 2 ms) performed by the ECU 20A.

In S204, the ECU 20A calculates the ionic differential value vibration strength S1 by integrating, among analysis results sent from the frequency analyzer 20lbA, the signal level of the knocking frequency band through the operation unit 20lcA. In S205, the ionic integral value S2 is calculated by integrating an ionic current signal in the cycle through the integrating unit 20ldA. The range of integrating an ionic current signal to calculate an ionic integral value may be inside the knocking window or one cycle as a whole and the range thereof is stored in the ECU 20A in advance. Next, in S206, the ECU 20A calculates the normalized value S3 of the ionic differential value vibration strength S1 normalized by dividing the ionic differential value vibration strength S1 by the ionic integral value S2 through the normalization unit 201eA and sends the calculation result to the knocking detection unit 20mA.

Next, in S207, the ECU 20A reads the number of revolutions Ne and the torque T of the engine and in S208, calculates a knocking determination threshold S03 set for each operating condition through the knocking detection unit 20mA. Next, in S209, the ECU 20A compares to determine whether the normalized value S3 sent from the normalization unit 201cA is larger than the knocking determination threshold S03 and if S3 ≤ S03, terminates a set of control by determining that no knocking has occurred. On the other hand, if S3 > S03, the ECU 20A determines that knocking has occurred and in S210, controls the ignition timing of the ignition system through the knocking avoidance controller 20nA such that the ignition timing of the ignition system is on the lagging side of the current value.

According to the second embodiment, as described above, the knocking vibration component can reliably and finely be extracted from an ionic current signal while the influence of the absolute value of the ionic current signal being removed and the occurrence of knocking of the engine can finely be detected by detecting an occurrence of knocking of the engine using a normalized value obtained by dividing an analysis result obtained by conducting the frequency analysis of the differential value as an amount of change of the ionic current signal by an integral value of the ionic current signal regardless of the absolute value of the ionic current signal when knocking occurs. In addition, by exercising knocking avoidance control by controlling the ignition timing based on the detection result, the combustion state of the engine can be controlled more finely.

### [Third embodiment]

In the second embodiment, the ionic differential value vibration strength is normalized based on the ionic integral value obtained by integrating a chronological signal of the ionic current value in the cycle, but by normalizing the ionic differential value in advance by dividing by the ionic current value at the corresponding time, the influence of the absolute value of the ionic current signal to be based on is removed and the correlation between the knocking strength and the ionic differential value vibration strength is further increased so that the detection precision of an occurrence of knocking of the engine is considered to be further improvable.

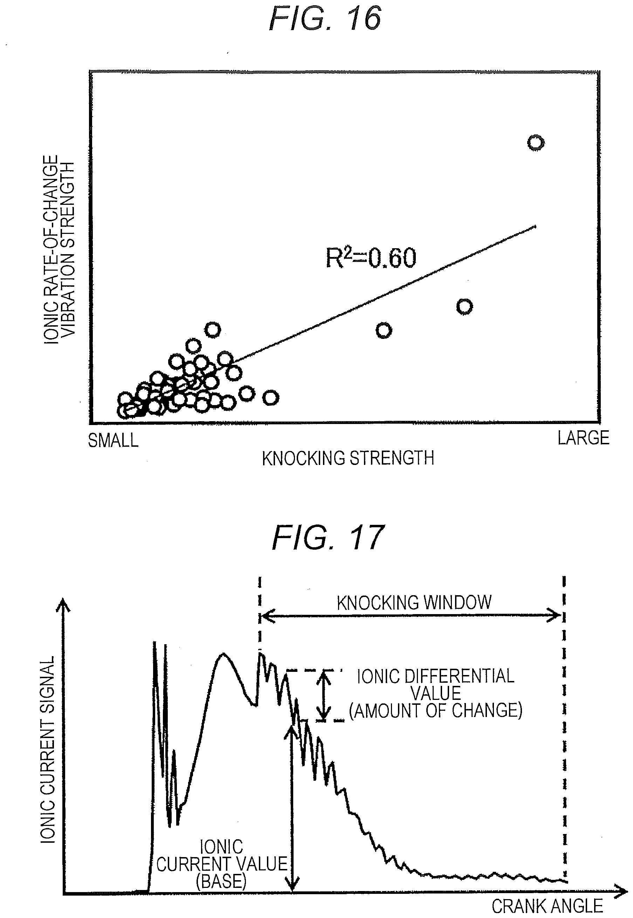

FIG. 16 shows the relationship between the knocking strength and ionic rate-of-change vibration strength. The ionic rate-of-change vibration strength is a value obtained by calculating a normalized value (also called an ionic rate of change) by dividing the ionic differential value by the ionic current value (ionic current instantaneous value) at the corresponding time (see FIG. 17) and integrating, among results obtained by conducting the FFT analysis of the ionic rate-of-change, the signal level of the knocking frequency band. It is verified that, as shown in FIG. 16, the correlation between the ionic rate-of-change vibration strength calculated by using results obtained by conducting the FFT analysis of an ionic rate-of-change and the knocking strength is still higher (the correlation coefficient R² is 0.60). This is because the influence of the absolute value of an ionic current signal for each combustion cycle is considered to be removable at each time by dividing the ionic differential value as an amount of change of the ionic current signal by the ionic current value at the corresponding time. Thus, in the third embodiment, an occurrence of knocking of the engine is detected based on the normalized value obtained by normalizing the ionic differential value by the ionic current value.

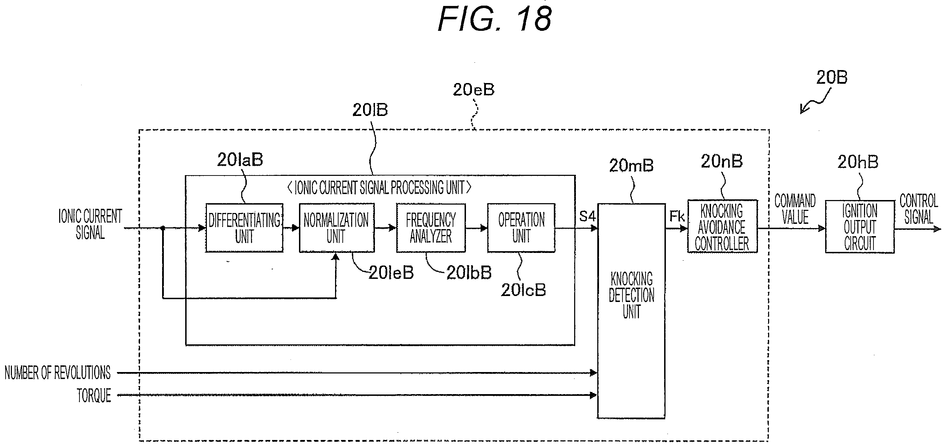

FIG. 18 shows the internal configuration of the third embodiment of ECU (control device) of the internal combustion engine according to the present invention and particularly shows the configuration in which knocking of an engine is detected based on an ionic current signal input from the ignition system and when an occurrence of knocking is detected, the ignition timing of the ignition system is controlled.

The control device in the third embodiment shown in FIG. 18 is different from the control device in the first and second embodiments described above in the method of detecting knocking of an engine and the other configuration is the same as that of the control device in the first and second embodiments. Thus, a detailed description of the configuration that is the same as that of the control device in the first and second embodiments is omitted.

As illustrated in FIG. 18, CPU 20eB of ECU 20B mainly includes an ionic current signal processing unit 20lB that processes the ionic current value as a signal, a knocking detection unit (detection unit) 20mB that detects an occurrence of knocking of an engine, and a knocking avoidance controller 20nB that avoids further knocking by controlling the ignition timing of the ignition system.

The ionic current signal processing unit 20lB mainly includes a differentiating unit 20laB that calculates a differential value of an ionic current value (ionic differential value), a normalization unit 20leB that calculates a normalized value (also called an ionic rate of change) by normalizing the differential value, a frequency analyzer 20lbB that conducts the frequency analysis of the ionic rate of change, and an operation unit 20lcB that calculates an ionic rate-of-change vibration strength from the analysis result.

An ionic current signal output from the ignition system is input into the differentiating unit 20laB and the normalization unit 20ldB of the ionic current signal processing unit 20lB. The differentiating unit 20laB calculates an ionic differential value by differentiating the ionic current signal in a preset period (knocking window) and sends the calculation result to the normalization unit 20leB. The normalization unit 20leB calculates an ionic rate of change by dividing the ionic differential value sent from the differentiating unit 20laB by the ionic current value at the corresponding time and sends the calculation result to the frequency analyzer 20lbB. The frequency analyzer 20lbB conducts the FFT analysis of the ionic rate of change sent from the normalization unit 20leB and sends the analysis result to the operation unit 20lcB. The operation unit 20lcB calculates an ionic rate-of-change vibration strength S4 by integrating, among analysis results sent from the frequency analyzer 20lbB, the signal level of the knocking frequency band and sends the calculation result to the knocking detection unit 20mB.

In addition to the signal (ionic rate-of-change vibration strength S4) processed by the ionic current signal processing unit 20lB, the number of revolutions and torque of the engine are input into the knocking detection unit 20mB. The knocking detection unit 20mB calculates a knocking determination threshold (determination threshold) from the number of revolutions and torque input above and determines whether knocking has occurred by comparing the knocking determination threshold and the signal ( ionic rate-of-change vibration strength S4) input from the ionic current signal processing unit 20lB. When an occurrence of knocking of the engine is detected, the knocking detection unit 20mB sets the knocking determination flag Fk to 1 and outputs the flag to the knocking avoidance controller 20nB.

If the knocking determination flag Fk from the knocking detection unit 20mB is 1, the knocking avoidance controller 20nB sends a command value to the ignition output circuit 20hB such that the ignition timing of the ignition system lags to avoid further knocking. Based on the command value, the ignition output circuit 20hB creates a control signal and sends the created control signal to the ignition system to control the ignition timing thereof.

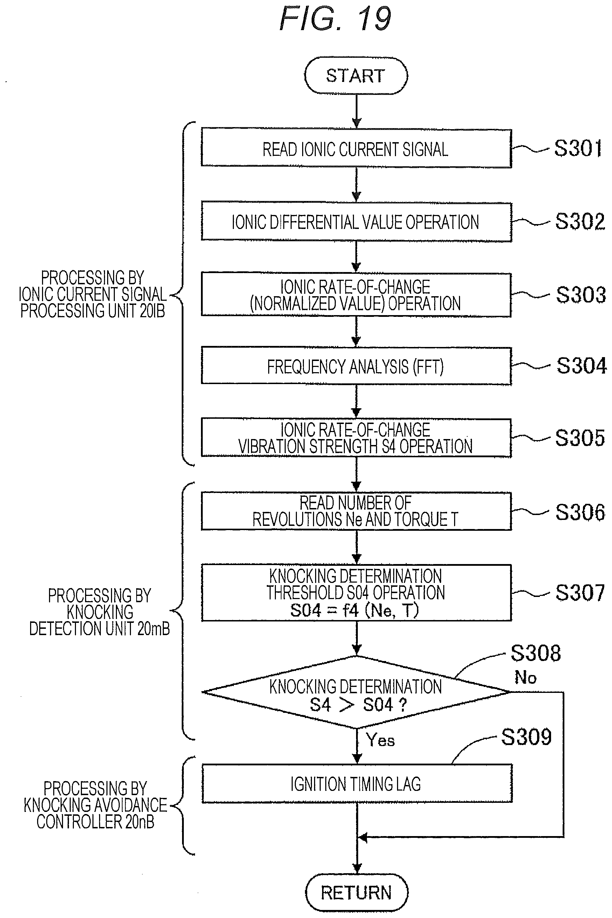

FIG. 19 concretely shows the knocking detection flow and the knocking avoidance control flow by the ECU (control device) shown in FIG. 18. The control flow shown in FIG. 19 is repeatedly performed by the ECU 20B in a predetermined period.

First, in S301, the ECU 20B reads an ionic current signal output from the ignition system. Next, in S302, the ECU 20B calculates an ionic differential value by differentiating the ionic current signal in the preset period (knocking window) through the differentiating unit 20laB of the ionic current signal processing unit 20lB. Next, in S303, the ECU 20B calculates an ionic rate of change by dividing the ionic differential value sent from the differentiating unit 20laB by the ionic current value at the corresponding time through the normalization unit 20leB. Next, in S304, the ECU 20B conducts the frequency (FFT) analysis of the ionic rate of change sent from the normalization unit 201eB through the frequency analyzer 20lbB. Here, in S304, it is necessary to determine frequency components of a few kHz to a few tens of kHz and thus, the arithmetic processing from S301 to S304 needs to be performed far faster (for example, a few tens of µs or so) than the period of control (for example, 2 ms) performed by the ECU 20B. On the other hand, arithmetic processing from S305 to S309 below is performed in the period of control (for example, 2 ms) performed by the ECU 20B.

In S305, the ECU 20B calculates the ionic rate-of-change vibration strength S4 by integrating, among analysis results sent from the frequency analyzer 20lbB, the signal level of the knocking frequency band through the operation unit 20lcB and sends the calculation result to the knocking detection unit 20mB. Next, in S306, the ECU 20B reads the number of revolutions Ne and the torque T of the engine and in S307, calculates a knocking determination threshold S04 set for each operating condition through the knocking detection unit 20mB. Next, in S308, the ECU 20B compares to determine whether the normalized value S4 sent from the operation unit 20lcB is larger than the knocking determination threshold S04 and if S4 ≤ S04, terminates a set of control by determining that no knocking has occurred. On the other hand, if S4 > S04, the ECU 20B determines that knocking has occurred and in S309, controls the ignition timing of the ignition system through the knocking avoidance controller 20nB such that the ignition timing of the ignition system is on the lagging side of the current value.

According to the third embodiment, as described above, the knocking vibration component can reliably and finely be extracted from an ionic current signal while the influence of the absolute value of the ionic current signal being removed and the occurrence of knocking of the engine can more finely be detected by detecting an occurrence of knocking of the engine using an ionic rate of change as a normalized value of the differential value as an amount of change of the ionic current signal by the ionic current value in advance regardless of the absolute value of the ionic current signal when knocking occurs. In addition, by exercising knocking avoidance control by controlling the ignition timing based on the detection result, the combustion state of the engine can be controlled still more finely.

In the first to third embodiments described above, a form in which the ionic current value detection unit that detects an ionic current generated during combustion is provided in the ignition system is described, but the arrangement position of the ionic current value detection unit may be changed when appropriate.

Also in the first to third embodiments described above, a form conducting mainly the FFT analysis as the frequency analysis is described, but if the combustion state of an internal combustion engine can be detected, any appropriate frequency analysis method can be applied.

The present invention is not limited to the first to third embodiments described above and includes various modifications, as long as these are comprised in the scope defined by the appended claims. For example, the first to third embodiments described above are described in detail to describe the present invention so as to be understood easily and the present invention is not necessarily limited to those including all described components. It is possible to replace a portion of components of a certain embodiment with components of other embodiments and also to add a component of a certain embodiment to components of another embodiment. In addition, additions, deletions, or substitutions of other components can be made for a portion of components of each embodiment.

Control lines and information lines considered to be necessary for description are shown and all control lines and information lines are not necessarily shown from a product viewpoint. Actually, almost all components may be considered to be mutually connected. Reference Signs List

- 1: air flow sensor
- 2: electronic control throttle
- 3: fuel injector
- 4: ignition system
- 4a: ignition plug
- 4b: secondary ignition coil
- 4c: primary ignition coil
- 4d: capacitor
- 4e: Zener diode
- 4f: voltage conversion resistor
- 4i: igniter
- 5: variable valve
- 5a: intake valve variable device
- 5b: exhaust valve variable device
- 6: intake pipe
- 7: cylinder head
- 8: exhaust pipe
- 9: air-fuel ratio sensor
- 10: three-way catalyst
- 11: exhaust temperature sensor
- 12: combustion chamber
- 13: crank angle sensor

- 14: cooling water temperature sensor
- 15: intake temperature sensor
- 16: accelerator opening sensor
- 17: high-pressure fuel pump
- 18: fuel pressure sensor
- 20: engine control unit (ECU) (control device)
- 20a: input circuit
- 20b: input/output port
- 20c: RAM
- 20d: ROM
- 20e: CPU
- 20f: electronic control throttle drive circuit
- 20g: injector drive circuit
- 20h: ignition output circuit
- 20j: variable valve drive circuit
- 20k: high-pressure fuel pump drive circuit
- 20l: ionic current signal processing unit
- 20la: differentiating unit
- 20lb: frequency analyzer
- 20lc: operation unit
- 20ldA: integrating unit
- 20leA: normalization unit
- 20m: knocking detection unit (detection unit)
- 20n: knocking avoidance controller
- 21: intake pressure sensor

- 41: spark ignition unit
- 42: ionic current value detection unit
- 100: engine (internal combustion engine)

## Claims

1. A control device (20) of an internal combustion engine (100) having an ionic current value detection unit (42) that detects an ionic current value during combustion, the control device (20) comprising:
an ionic current signal processing unit (201) that performs signal processing of the ionic current value;
a detection unit (20m) that detects a combustion state of the internal combustion engine (100) based on a processing result by the ionic current signal processing unit (201);
wherein the ionic current signal processing unit (201) includes a differentiating unit (201a, 201aA, 201aB) that calculates a differential value of the ionic current value;
**characterized in** the control device further comprising
a drive circuit (20f, 20g, 20h, 20j, 20k) that controls ignition timing of an ignition system (4) of the internal combustion engine (100) based on a vibration strength of the internal combustion engine (100) detected by the detection unit (20m) depending on the signal processing of the ionic current value,
wherein the ionic current signal processing unit (201) further includes a frequency analyzer (201b, 201ba, 201bB) that conducts frequency analysis of the differential value, and
an operation unit (201c) that calculates the vibration strength by integrating, among analysis results sent from the frequency analyzer (201b), the signal level of a knocking frequency band.

2. The control device (20) of an internal combustion engine (100) according to claim 1, wherein the ionic current signal processing unit (201) further includes an integrating unit that calculates an integral value of the ionic current value, and a normalization unit that calculates a normalized value using an analysis result by the frequency analyzer and the integral value.

3. The control device (20) of an internal combustion engine (100) according to claim 2, wherein the normalization unit calculates the normalized value dividing the analysis result by the frequency analyzer by the integral value.

4. The control device (20) of an internal combustion engine (100) according to claim 1, wherein the ionic current signal processing unit (201) further includes a normalization unit that calculates a normalized value from the ionic current value and the differential value and the frequency analyzer that conducts frequency analysis of the normalized value.

5. The control device (20) of an internal combustion engine (100) according to claim 4, wherein the normalization unit calculates the normalized value by dividing the differential value by the ionic current value at a time corresponding to the differential value.

6. The control device (20) of an internal combustion engine (100) according to claim 1, wherein the detection unit (20m) uses a determination threshold obtained from a number of revolutions and torque of the internal combustion engine (100) to detect the combustion state of the internal combustion engine (100).

## Patentansprüche

1. Steuervorrichtung (20) einer Brennkraftmaschine (100), die eine Ionenstromwert-Detektionseinheit (42) aufweist, die einen
Ionenstromwert während der Verbrennung detektiert, wobei die Steuervorrichtung (20) Folgendes umfasst:
eine Ionenstromsignal-Verarbeitungseinheit (20l), die eine Signalverarbeitung des lonenstromwerts ausführt;
eine Detektionseinheit (20m), die einen Verbrennungszustand der Brennkraftmaschine (100) anhand eines Verarbeitungsergebnisses durch die lonenstrahlsignal-Verarbeitungseinheit (20l) detektiert;
wobei die Ionenstromsignal-Verarbeitungseinheit (20l) eine Differenziereinheit (201a, 201aA, 201aB) enthält, die einen differenziellen Wert des Ionenstromsignals berechnet;
**dadurch gekennzeichnet, dass** die Steuervorrichtung ferner Folgendes umfasst:
eine Ansteuerschaltung (20f, 20g, 20h, 20j, 20k), die den Zündzeitpunkt eines Zündsystems (4) der Brennkraftmaschine (100) anhand einer Vibrationsstärke der Brennkraftmaschine (100), die durch die Detektionseinheit (20m) detektiert wird, in Abhängigkeit von der Signalverarbeitung des Ionenstromwerts steuert,
wobei die lonenstromsignal-Verarbeitungseinheit (20l) ferner Folgendes enthält:
einen Frequenzanalysator (201b, 201ba, 201bB), der an dem differenziellen Wert eine Frequenzanalyse ausführt, und
eine Betriebseinheit (201c), die die Vibrationsstärke durch Integration von Analyseergebnissen, die von dem Frequenzanalysator (201b) geschickt werden, den Signalpegel eines Klopf-Frequenzbandes berechnet.

2. Steuervorrichtung (20) einer Brennkraftmaschine (100) nach Anspruch 1, wobei die Ionenstromsignal-Verarbeitungseinheit (20l) ferner eine Integrationseinheit, die einen Integrationswert des lonenstromwerts berechnet, und eine Normierungseinheit, die einen normierten Wert unter Verwendung eines Analyseergebnisses des Frequenzanalysators und des Integrationswerts berechnet, umfasst.

3. Steuervorrichtung (20) einer Brennkraftmaschine (100) nach Anspruch 2, wobei die Normierungseinheit den normierten Wert durch Dividieren des Analyseergebnisses des Frequenzanalysators durch den Integrationswert berechnet.

4. Steuervorrichtung (20) einer Brennkraftmaschine (100) nach Anspruch 1, wobei die Ionenstromsignal-Verarbeitungseinheit (20l) ferner eine Normierungseinheit enthält, die einen normierten Wert aus dem lonenstromwert und dem differenziellen Wert berechnet, wobei der Frequenzanalysator eine Frequenzanalyse an dem normierten Wert ausführt.

5. Steuervorrichtung (20) einer Brennkraftmaschine (100) nach Anspruch 4, wobei die Normierungseinheit den normierten Wert durch Dividieren des differenziellen Wertes durch den lonenstromwert zu einem dem differenziellen Wert entsprechenden Zeitpunkt berechnet.

6. Steuervorrichtung (20) einer Brennkraftmaschine (100) nach Anspruch 1, wobei die Detektionseinheit (20m) einen Bestimmungsschwellenwert verwendet, der aus der Drehzahl und dem Drehmoment der Brennkraftmaschine (100) erhalten wird, um den Verbrennungszustand der Brennkraftmaschine (100) zu detektieren.

## Revendications

1. Dispositif de commande (20) d'un moteur à combustion interne (100) ayant une unité de détection de valeur de courant ionique (42) qui détecte une valeur de courant ionique pendant une combustion, le dispositif de commande (20) comprenant :
une unité de traitement de signal de courant ionique (20l) qui exécute un traitement de signal de la valeur de courant ionique ;
une unité de détection (20m) qui détecte un état de combustion du moteur à combustion interne (100) sur la base d'un résultat de traitement via l'unité de traitement de signal de courant ionique (20l) ;
dans lequel l'unité de traitement de signal de courant ionique (20l) inclut une unité de différentiation (20la, 20laA, 20laB) qui calcule une valeur différentielle de la valeur de courant ionique ;
**caractérisé en ce que** le dispositif de commande comprend en outre :
un circuit pilote (20f, 20g, 20h, 20j, 20k) qui commande une temporisation d'allumage d'un système d'allumage (4) du moteur à combustion interne (100) sur la base d'une force de vibration du moteur à combustion interne (100) détectée par l'unité de détection (20m) en dépendance du traitement de signal de la valeur de courant ionique,
dans lequel l'unité de traitement de signal de courant ionique (20l) inclut en outre :
un analyseur de fréquence (20lb, 20lba, 20lbB) qui conduit une analyse de fréquence de la valeur différentielle, et
une unité opérationnelle (20lc) qui calcule la force de vibration en intégrant, parmi des résultats d'analyse envoyés depuis l'analyseur de fréquence (20lb), le niveau de signal d'une bande de fréquence de cliquetis.

2. Dispositif de commande (20) d'un moteur à combustion interne (100) selon la revendication 1, dans lequel l'unité de traitement de signal de courant ionique (20l) inclut en outre une unité d'intégration qui calcule une valeur intégrale de la valeur de courant ionique, et une unité de normalisation qui calcule une valeur normalisée en utilisant un résultat d'analyse via l'analyseur de fréquence et la valeur intégrale.

3. Dispositif de commande (20) d'un moteur à combustion interne (100) selon la revendication 2, dans lequel l'unité de normalisation calcule la valeur normalisée en divisant le résultat d'analyse via l'analyseur de fréquence par la valeur intégrale.

4. Dispositif de commande (20) d'un moteur à combustion interne (100) selon la revendication 1, dans lequel l'unité de traitement de signal de courant ionique (20l) inclut en outre une unité de normalisation qui calcule une valeur normalisée à partir de la valeur de courant ionique et de la valeur différentielle, et l'analyseur de fréquence qui conduit une analyse de fréquence de la valeur normalisée.

5. Dispositif de commande (20) d'un moteur à combustion interne (100) selon la revendication 4, dans lequel l'unité de normalisation calcule la valeur normalisée en divisant la valeur différentielle par la valeur de courant ionique à un instant correspondant à la valeur différentielle.

6. Dispositif de commande (20) d'un moteur à combustion interne (100) selon la revendication 1, dans lequel l'unité de détection (20m) utilise un seuil de détermination obtenu à partir d'un nombre de tours et d'un couple du moteur à combustion interne (100) pour détecter l'état de combustion du moteur à combustion interne (100).
